# EUROPÄISCHE PATENTSCHRIFT

(11) **EP 1 350 863 B1**
(45) Veröffentlichungstag und Bekanntmachung des Hinweises auf die Patenterteilung: **09.08.2006**
(21) Anmeldenummer: 02006164.4
(22) Anmeldetag: 19.03.2002
(51) Int. Cl.: C23C 14/04

(54) **Vorrichtung und Verfahren zum gerichteten Aufbringen von Depositionsmaterial auf ein Substrat**
Process and apparatus for depositing on a substrate a flux of coating material of prefered orientation
Procédé et appareillage pour le dépot sur un substrat d'un flux de matière préférentiellement orienté

(43) Veröffentlichungstag der Anmeldung: 08.10.2003
(73) Patentinhaber: Scheuten Glasgroep, 5900 AA Venlo (NL)
(72) Erfinder: Kaas, Patrick, 5632 MN Eindhoven (NL); Geyer, Volker, 41372 Niederkrüchten (DE)
(74) Vertreter: Jostarndt, Hans-Dieter

(56) Entgegenhaltungen:
- EP-A- 0 509 305
- EP-A- 0 717 432
- US-A- 3 627 569
- US-A- 4 776 868
- US-A- 5 415 753
- US-B1- 6 168 832
- US-B1- 6 210 540
- PATENT ABSTRACTS OF JAPAN vol. 1995, no. 08, 29. September 1995 (1995-09-29) & JP 07 113172 A (SONY CORP), 2. Mai 1995 (1995-05-02)
- PATENT ABSTRACTS OF JAPAN vol. 1998, no. 10, 31. August 1998 (1998-08-31) & JP 10 121234 A (RICOH CO LTD), 12. Mai 1998 (1998-05-12)
- PATENT ABSTRACTS OF JAPAN vol. 1997, no. 02, 28. Februar 1997 (1997-02-28) & JP 08 260139 A (SONY CORP), 8. Oktober 1996 (1996-10-08)

## Beschreibung

Die Erfindung betrifft eine Vorrichtung zum gerichteten Aufbringen von Depositionsmaterial auf ein Substrat, insbesondere zum Fokussieren des Sputterflusses in einer PVD-Anlage auf einen engen Winkelbereich.

Die Erfindung betrifft ferner ein Verfahren zum gerichteten Aufbringen von Depositionsmaterial auf ein Substrat.

In der Industrie besteht für verschiedene Beschichtungstechniken bzw. -verfahren ein Bedarf nach Vorrichtungen zum gerichteten Beschichten von Substraten. Insbesondere erfordern einige Anwendungen spezielle PVD-Anlagen (Physical Vapor Deposition), die in der Lage sind, das von einem Target abgesputterte Material auf einen engen Winkelbereich zu fokussieren und unter unterschiedlichen Winkeln auf ein Substrat aufzubringen.

Normalerweise werden derartige Kathodenzerstäubungs- oder Sputteranlagen so ausgelegt, dass in kürzester Zeit eine maximale Menge an Sputtermaterial abgeschieden werden kann. Die Verteilung des Sputtermaterials auf dem Substrat soll hierbei möglichst homogen sein. Um dies zu erreichen, werden beispielsweise Blenden eingesetzt, die den Sputterfluss geometrisch begrenzen. Derartige Blenden begrenzen den Sputterfluss jedoch nur in den Außenbereichen, während die Sputterstrahlen nach wie vor stark gestreut sind.

Aus der Deutschen Offenlegungsschrift 198 19 785 ist eine Zerstäubungskathode nach dem Magnetron-Prinzip bekannt, bei der zur Erhöhung der Sputterrate quer zur Bewegungsrichtung der Ladungsträger ein Magnetfeld angelegt wird.

Aus der Deutschen Offenlegungsschrift 195 06 799 ist eine Sputtervorrichtung zur Herstellung dünner Schichten bekannt, bei der zur Steuerung der Sputterteilchen eine Steuerelektrodeneinrichtung mit hinreichend großer geometrischer Durchlässigkeit in den Raum zwischen Plasma und Substrat eingebracht wird. Durch diese Steuerelektrodeneinrichtung kann die Bewegung der gesputterten und positiv geladenen Targetteilchen beeinflusst werden.

Die Europäische Patentanmeldung EP 0 509 305 beschreibt ein Verfahren zur Abscheidung von Leiterbahnen in Vertiefungen mit großem Seitenverhältnis. Das Seitenverhältnis ist durch das Verhältnis der Tiefe zur Breite der Vertiefung gegeben. Zur Abscheidung wird ein Verfahren des reaktiven Sputterns durch einen Kollimator verwendet, wobei der Kollimator ein ähnliches Seitenverhältnis wie die Vertiefung aufweist, auf deren Boden die Leiterbahn aufzubringen ist.

Die US-Patentschrift US 4,776,868 offenbart ein Verfahren zur Herstellung von konvexen Erhöhungen auf einem Substrat, wobei die Erhöhungen zu Linsen verarbeitet werden. Die Erhöhungen werden dadurch aufgebracht, dass in einem Vakuum ein Dampf einer Substanz von einer Quelle abgeschieden und durch eine Maske mit Öffnungen geleitet wird, bevor der Dampf auf das Substrat trifft. Die Dicke der Maske ist so gewählt, dass ein Dampfkegel konvergierend in eine Öffnung eintritt und divergierend wieder heraustritt und auf das Substrat trifft.

Aus der US-Patentschrift US 3,627,569 sind ein Verfahren und eine Vorrichtung zur Dampfabscheidung von dünnen Filmen bekannt, bei denen das Dickeprofil und der zu beschichtende Flächenbereich stark durch eine richtende Vorrichtung kontrolliert werden. Die richtende Vorrichtung besteht aus mehreren länglichen Kanälen, um den Dampf zwischen der Quelle und einem Substrat zu kanalisieren. Dies bewirkt eine gleichmäßige Verteilung und eine Ausrichtung des Dampfstroms.

Die US-Patentschrift US 5,415,753 beschreibt eine Lochblende, die sich zwischen einem Sputtertarget und einem mit dem Targetmaterial zu beschichtenden Substrat befindet. Die Lochblende ist im Wesentlichen so ausgestaltet, dass sie aufgrund eines geringen Seitenverhältnisses nicht richtend wirkt. Die Öffnungen der Lochblende fangen einen bestimmten Prozentteil der Sputterpartikel ab, während andere Sputterpartikel zur Abscheidung auf dem Substrat hindurchgelassen werden. Die Vorrichtung bewirkt, dass die Abscheidungsrate der Lochblende geringer ist als die Abscheidungsrate des Sputtervorgangs.

Die US-Patentschrift US 6,168,832 offenbart ein Verfahren zur Vakuumbedampfung von einer oder mehrerer Schichten auf ein Substrat, wobei die Dickenverteilung der Schichten durch eine drei-dimensionale Maske gesteuert wird, die zwischen dem Substrat und einer Dampfquelle positioniert ist. In einem beschriebenen Ausführungsbeispiel rotieren sowohl das Substrat als auch die Maske, wobei die Maske kreisrund ist und fächerförmig angeordnete Öffnungsschlitze aufweist.

Die US-Patentschrift US 6,210,540 beschreibt eine Maske, die über der Mitte einer Abscheidungsquelle positioniert ist, um den Flusswinkel von der Quelle zu begrenzen. Vor der Maske rotiert eine Vorrichtung, auf deren Umfang ein zu beschichtendes Substrat aufgebracht ist. Durch die Maske wird der Bereich der Vorrichtung abgeschirmt, welcher der Abscheidung nicht ausgesetzt sein soll. Die Rotation der Vorrichtung bewirkt eine Beschichtung der Seitenflächen des Substarts unter sich ändernden Winkeln.

Aus der Europäischen Patentanmeldung EP 0 717 432 ist eine Vorrichtung zum Sputtern eines Materials auf ein Substrat bekannt, bei dem zwischen dem Sputtertarget und dem zu beschichtenden Substrat ein Rohr angebracht ist. Das Rohr bewirkt, dass selektierte Bereiche des Targetmaterialstroms das Substrat nicht erreichen.

Die Japanische Patentanmeldung JP 07 113 172 beschreibt einen Kollimator, der sich in einer Vorrichtung zum Aufbringen eines dünnen Films auf ein Substrat befindet, wobei der Kollimator eine Vielzahl von gleichmäßig angeordneten Schlitzen aufweist. Die Schlitze verlaufen dabei in einem Winkel zur Substratoberfläche und die von einer darüber liegenden Quelle abgescheiedenen Materialstrahlen passieren die Schlitze.

Die Japanische Patentanmeldung JP 10 121 234 beschreibt ebenfalls eine Sputtervorrichtung mit einem Kollimator, welche die Asymmetrie der Filmbildung eliminieren bzw. reduzieren soll.

Ferner ist aus der Japanischen Patentanmeldung JP 1 260 139 ein Kollimator mit mehreren Öffnungen bekannt, der zwischen einem Sputtertarget und einem Wafer positioniert ist. Die inneren Flächen der Öffnungen sind sägezahnförmig mit spitz zulaufenden Abschnitten (kranzförmige Nuten) ausgebildet.

Aufgabe der Erfindung ist es, eine gattungsgemäße Vorrichtung so auszubilden, dass sie ein auf einen engen Winkelbereich begrenztes und gerichtetes Aufbringen von Depositionsmaterial auf ein Substrat ermöglicht

Aufgabe der Erfindung ist es, eine gattungsgemäße Vorrichtung so auszubilden, dass sie ein auf einen engen Winkelbereich begrenztes und gerichtetes Aufbringen von Depositionsmaterial auf ein Substrat ermöglicht.

Erfindungsgemäß wird diese Aufgabe durch ein Verfahren gemäß dem Gegenstand des Anspruchs 1 gelöst. Die Aufgabe wird ferner durch eine Vorrichtung gemäß dem Gegenstand des Anspruchs 2 gelöst. Vorteilhafte Weiterbildungen der erfindungsgemäßen Vorrichtung ergeben sich aus den Unteransprüchen 3-13.

Erfindungsgemäß ist die gattungsgemäße Vorrichtung mit einem Filter ausgestattet, der das aufzubringende Depositionsmaterial auf einen engen Winkelbereich fokussiert. Insbesondere ist eine Sputtervorrichtung mit einem Filter ausgestattet, der so zwischen Sputtertarget und Substrat eingebracht ist, dass der Sputterteilchenfluss durch ihn hindurchgeleitet und fokussiert wird.

Der erfindungsgemäße Filter besteht aus mehreren kanalförmigen Einzelstrukturen. Die Fokussierung des Sputterteilchenflusses erfolgt aufgrund der geometrischen Abmessungen der einzelnen Filterstrukturen, wobei das Design des Filters auf geometrischen Strahlüberlegungen beruht. Beim Sputtervorgang bildet sich auf dem Target ein Sputtergraben in Form einer ovalförmigen Vertiefung aus, aus der die Targetteilchen herausgesputtert werden. Tritt nun ein in viele Richtungen gestreuter Sputterteilchenfluss einer Punktquelle eines solchen Sputtergrabens in eine Einzelstruktur des erfindungsgemäßen Filters ein, werden nur die Sputterteilchen hindurchgelassen, die in einem bestimmten Winkelbereich β eingetreten sind. Dieser maximale Öffnungswinkel β = 2 x α ergibt sich aus dem Zusammenhang tan α = B/L, wobei B die Breite und L die Länge der Filtereinzelstruktur darstellt. Sputterteilchen die außerhalb dieses Winkelbereichs in die Struktur eingetreten sind, werden an den Innenwänden der Struktur abgeschieden und somit eliminiert. Der austretende Sputterfluss wird so auf einen engen Winkelbereich begrenzt, der durch die Abmessungen der Filterstruktur eingestellt werden kann.

Der Filter besteht aus mehreren Einzelstrukturen, die vorzugsweise so nebeneinander angeordnet sind, dass der Hauptanteil des Sputterflusses, der vom Sputtergraben des Targets ausgeht, durch die Filterstrukturen geleitet und fokussiert werden kann.

Die Einzelstrukturen des Filters können unterschiedlich ausgeformt sein. Der erfindungsgemäße Filter kann ferner nicht nur für Sputterverfahren, sondern auch für andere Beschichtungsverfahren verwendet werden, bei denen Deposititionsmaterial gerichtet und auf einen engen Winkelbereich fokussiert werden soll.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: den bekannten Stand der Technik von Blenden bei PVD-Anlagen;
- Fig. 2: den Einfluss einer Einzelstruktur eines Filters auf die Sputterflussrichtung einer Punktquelle;
- Fig. 3: die Wirkung einer Mehrfachstruktur eines Filters auf die Sputterflussrichtung einer Zerstäubungskathode;
- Fig. 4: den maximalen Öffnungswinkel des gefilterten Sputterflusses;
- Fig. 5, 6, 7, 8: verschiedene Ausformungen von Filterstrukturen;
- Fig. 9, 10: Ausführungsbeispiele für Inline-Prozesse mit geneigter Kathode;
- Fig. 11, 12: Ausführungsbeispiele mit waagerechter Kathode und geneigtem Sputterplasma und
- Fig. 13: ein Ausführungsbeispiel mit Rotativkathode.

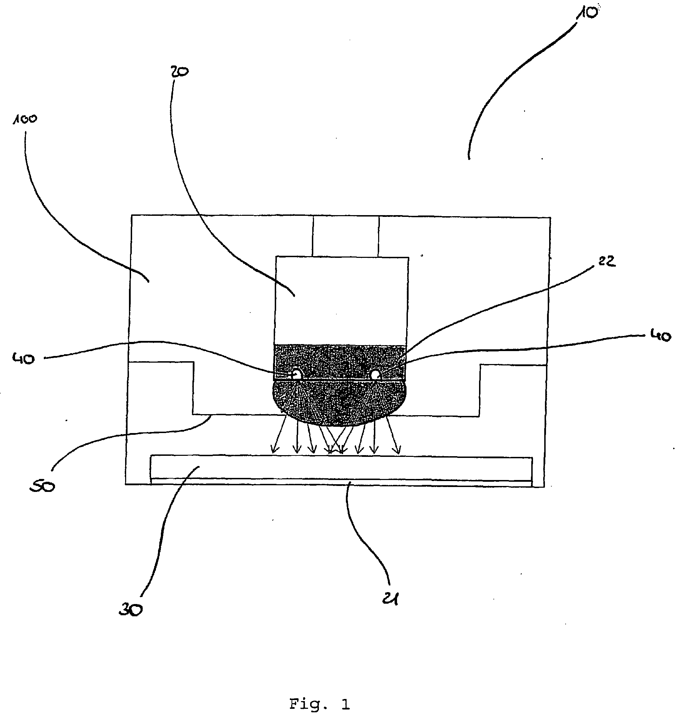

Die Zeichnung in Fig. 1 stellt vereinfacht den Stand der Technik bei Kathodenzerstäubungsanlagen (PVD-Anlagen) dar. Die Anlage 10 umfasst dabei eine Kathode 20, eine Anode 21 und ein Plasma, das zwischen den beiden Elektronen gezündet wurde. Vor der Kathode bildet sich ein Spannungsabfall aus, der die positiv geladenen Teilchen des Plasmas beschleunigt, so dass diese auf ein Sputtertarget 22 treffen, das sich vor der Kathode befindet. Dort schlagen die Teilchen des Plasmas einzelne Atome bzw. Moleküle heraus, die dann nach allen Richtungen gestreut auf das Substrat 30 treffen und dort eine Schicht ausbilden, deren Zusammensetzung der Targetzusammensetzung entspricht. Beim Sputtervorgang bildet sich auf dem Target 22 ein Sputtergraben oder sogenanntes "Racetrack" in Form einer Vertiefung mit ovalförmigem Verlauf aus, da die Teilchen nicht von der gesamten Targetfläche, sondern nur im Bereich dieser ovalförmigen Struktur abgesputtert werden. In der Zeichnung sind zwei Punktquellen 40 eines solchen Sputtergrabens auf dem Target dargestellt, von denen in alle Richtungen Teilchen abgesputtert werden.

Derartige Sputterkathoden und -anlagen werden dabei vorzugsweise so ausgelegt, dass in kürzester Zeit eine maximale Menge an Sputtermaterial abgeschieden wird. Damit die Beschichtung des Substrats 30 möglichst homogen erfolgt, wird der Sputterfluss beispielweise durch die Öffnung einer Blende 50 auf das Substrat 30 geleitet. Aus der Zeichnung ist jedoch ersichtlich, dass mittels einer Blende kein fokussierter und gerichteter Sputterfluss möglich ist, da der Sputterfluss immer noch stark gestreut wird und nur die Streuung in die Außenbereiche unterbunden wird.

Die Erfindung sieht daher vor, eine Vorrichtung zum Aufbringen von Depositionsmaterial mit einem Filter auszustatten, der das Depositionsmaterial auf einen engen Winkelbereich fokussiert. Bei den Vorrichtungen kann es sich um jegliche Anlagen handeln, bei denen Depositionsmaterial in Form von Teilchen auf ein Substrat aufgebracht wird. Beispielsweise kann es sich um PVD-, Sprüh- und/oder CVD-Anlagen handeln.

Insbesondere sieht die Erfindung daher vor, eine Kathodenzerstäubungs- oder Sputteranlage mit einem Filter auszustatten, welcher den Sputterfluss auf einen engen Winkelbereich begrenzt. Der Filter wird dabei zwischen wenigstens einer Zerstäubungskathode mit Sputtertarget und dem zu beschichtenden Substrat eingebracht, so dass der Fluss der abgesputterten Teilchen durch die Filterstruktur geleitet wird.

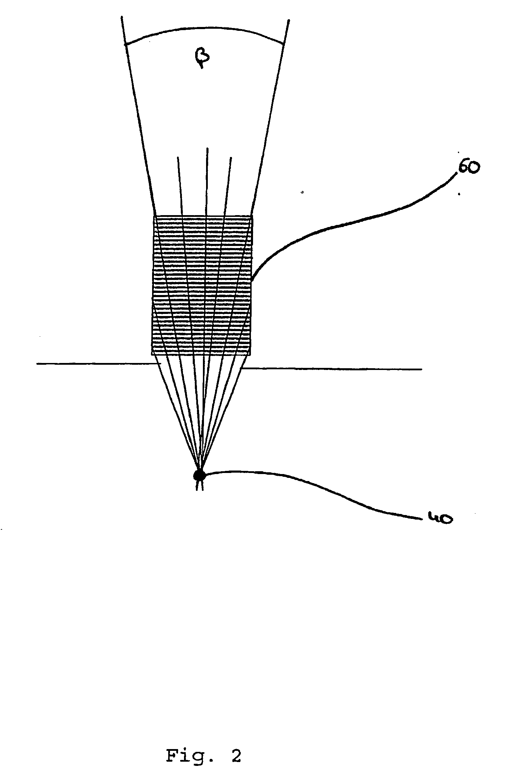

Das Design der Filterstruktur beruht auf geometrischen Strahlüberlegungen, wobei die geometrischen Abmessungen so gewählt sind, dass außerhalb eines bestimmten Winkelbereichs gestreute Sputterrichtungen eliminiert werden und der Sputterstrahl so auf den entsprechenden Winkelbereich begrenzt wird. Der Zeichnung in Fig. 2 ist die Wirkung einer Einzelstruktur eines solchen Filters auf eine Punktquelle zu entnehmen. Wird die Einzelstruktur 60 in die Sputterstrahlen, die von einer Punktquelle 40 eines Targets ausgehen, eingebracht, filtert sie die nach außen streuenden Strahlen heraus, so dass die Sputterstrahlen, die aus der Filterstruktur heraustreten, auf einen bestimmten Winkelbereich β begrenzt sind. Sputterstrahlen außerhalb dieses Winkelbereichs werden an den Innenwänden der Struktur abgeschieden und somit eliminiert.

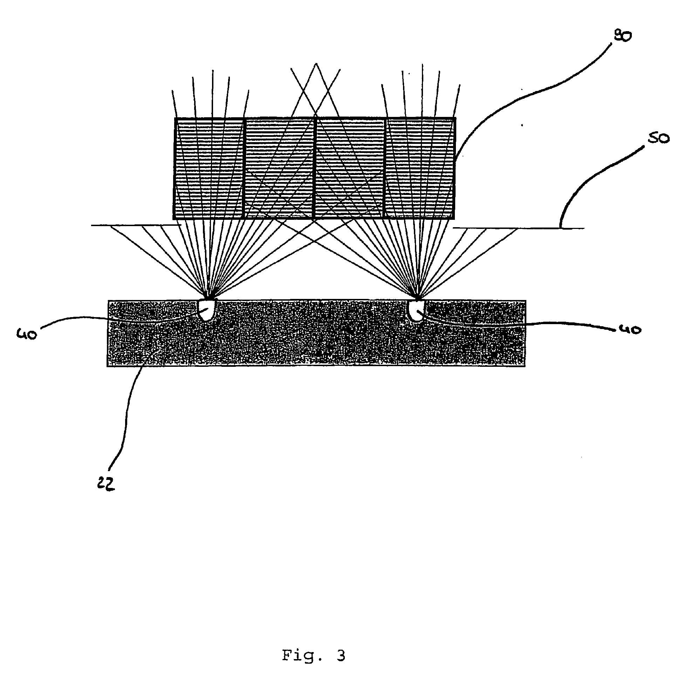

Der Fig. 3 ist die Wirkung einer Mehrfachstruktur eines erfindungsgemäßen Filters auf die Sputterflussrichtungen eines Targets 22 zu entnehmen. Dabei wird der Filter aus mehreren nebeneinander angeordneten Einzelstrukturen gebildet, und diese Mehrfachstruktur 90 eines solchen Filters befindet sich in den Sputterstrahlen mehrerer Punktquellen 40 eines Targets 22. Bei den in der Zeichnung dargestellten Punktquellen handelt es sich um Punktquellen im Sputtergraben des Targets 22. Die Mehrfachstruktur des Filters 90 filtert die unerwünschten Sputterrichtungen heraus und begrenzt so den Winkelbereich der gesamten abgesputterten Teilchenstrahlen, die durch die Mehrfachstruktur treten. Hinter dem Filter entsteht ein gerichteter Sputterfluss, der es ermöglicht, das Depositionsmaterial gerichtet unter einem Winkel auf ein Substrat aufzubringen.

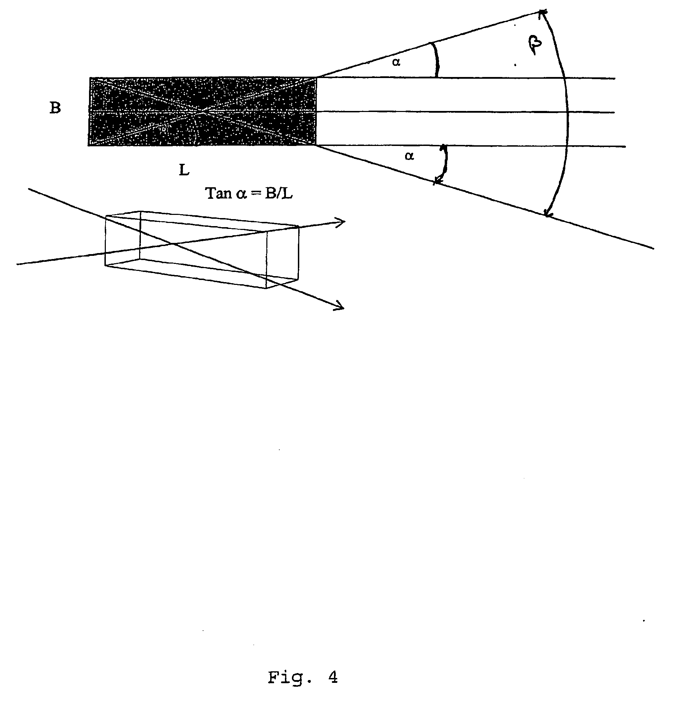

Der Zeichnung in Fig. 4 sind die geometrischen Verhältnisse der Einzelstrukturen eines Filters zu entnehmen. Dabei handelt es sich vorzugsweise um kanalförmige Strukturen. Der maximale Öffnungswinkel des gefilterten Sputterflusses ist abhängig von der Geometrie der Einzelstruktur, wobei im dargestellten Ausführungsbeispiel eine Kanalstruktur mit rechteckigem Querschnitt gewählt wurde. Der maximale Öffnungswinkel β = 2 x α wird hierbei durch das Verhältnis von Öffnungsweite B zu Strukturlänge L bestimmt, da α mit der Formel tan α = B/L berechnet werden kann. Der Öffnungswinkel □ liegt typischerweise in der Größenordnung von 10 bis 120 Grad.

Die Länge L ist durch die Länge des Kanals der Struktur gegeben, während die Breite B durch den weitesten Querschnitt der Struktur gegeben ist. Die Breite B liegt vorzugsweise in der Größenordnung von 2 bis 25 mm, während sich die Länge L abhängig von dem gewünschten Öffnungswinkel nach den Beziehungen tan α = B/L und β = 2 x α berechnen lässt.

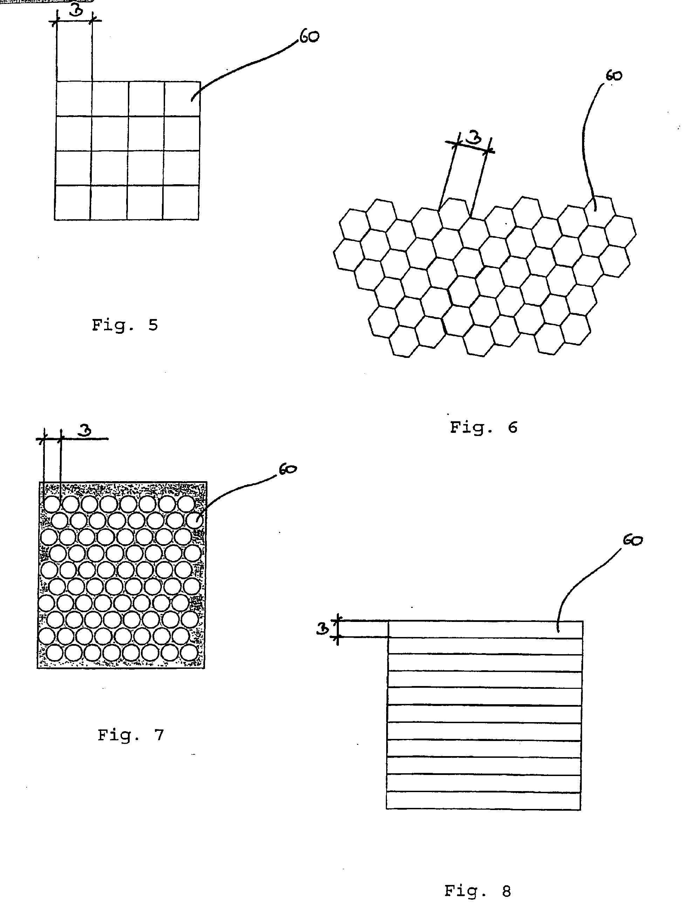

Die Ausformung der Strukturen kann dem Zweck entsprechend gewählt werden und ist somit nicht auf einen rechteckigen Querschnitt begrenzt, wie es in Fig. 8 dargestellt ist. In Fig. 5, 6 und 7 sind Ausführungsbeispiele von Filterstrukturen mit unterschiedlichen Querschnitten dargestellt. Dabei kann es sich beispielsweise um Strukturen mit quadratischem, wabenförmigem oder rundem Querschnitt handeln. Wenn es als zweckmäßig erachtet wird, können innerhalb einer Mehrfachstruktur auch verschiedene Querschnitte realisiert werden.

Wird ein Kanal mit rundem Querschnitt gewählt, ist als Breite B zweckmäßigerweise der Durchmesser des Kanals zu nehmen. Wird ein wabenförmiger Querschnitt gewählt, ist als Breite B der weiteste Querschnitt der Struktur zu nehmen. Die Anzahl der Einzelstrukturen innerhalb eines Filters hängt von der Anwendung und dem zu erzielenden Winkelbereich ab. Typische Anzahlen für z.B.quadratische Kanäle innerhalb einer Struktur liegen in der Größenordnung von 1600/m² bis 250.000/m².

Zur Bildung der Filterstrukturen eignen sich vielfältige Materialien, welche die jeweils an sie gestellten Anforderungen erfüllen. Dazu zählen Stabilität, chemische und physikalische Beständigkeit und gute Möglichkeit der Reinigung. Als Materialien kommen beispielsweise geeignete Kunststoffe, Aluminiumlegierungen, Eisen- oder Stahllegierungen in Frage, aus denen der Filter zu wenigstens 80% besteht. Die Dicke des Stegmaterials wird vorzugsweise so gewählt, dass die Stabilität der Struktur gewährleistet ist, aber keine zu großen Abschattungen entstehen. Typische Stegdicken liegen in der Größenordnung von 0,05 mm bis 2 mm.

Des weiteren hat es sich als zweckmäßig erwiesen, für den Filter Strukturen zu verwenden, die eine leichte Reinigung ermöglichen. Dies ist beispielsweise bei den lamellenartigen Strukturen in Fig.8 möglich, bei denen der rechteckige Querschnitt der Einzelstrukturen sehr lang ausgebildet ist und nur wenige Querträger die Struktur versteifen. So können die Innenwände der Strukturen leicht dadurch gereinigt werden, dass ein Reinigungsgerät wie eine Bürste der Länge nach durch den Querschnitt bewegt wird. Falls die Anwendung es nur erfordert, dass die Fokussierung von Teilchenstrahlen lediglich in Querrichtung zu den Einzelstrukturen erfolgt, reichen derartige Strukturen mit lamellenförmigen Querschnitten aus und lassen sich mit geringem Aufwand reinigen.
Prinzipiell sollten die Strukturen möglichst keine schwer zu reinigenden Bereiche aufweisen. Ist eine mechanische Reinigung beispielsweise durch Bürsten oder Sandstrahlen nicht möglich, können als Reinigungsprozess beispielsweise Ätzverfahren zur Anwendung kommen. Andere Reinigungsverfahren sind ebenfalls möglich. Die Art der Reinigung richtet sich zweckmäßigerweise nach der Art des Filtermaterials, der Ausformung des Filters und des verwendeten Targetmaterials. Ist nicht vorgesehen, den Filter zu reinigen, sollte er zweckmäßigerweise aus einem Material bestehen, dass sich in Verbindung mit dem abgeschiedenen Sputtermaterial leicht und kostengünstig entsorgen lässt.

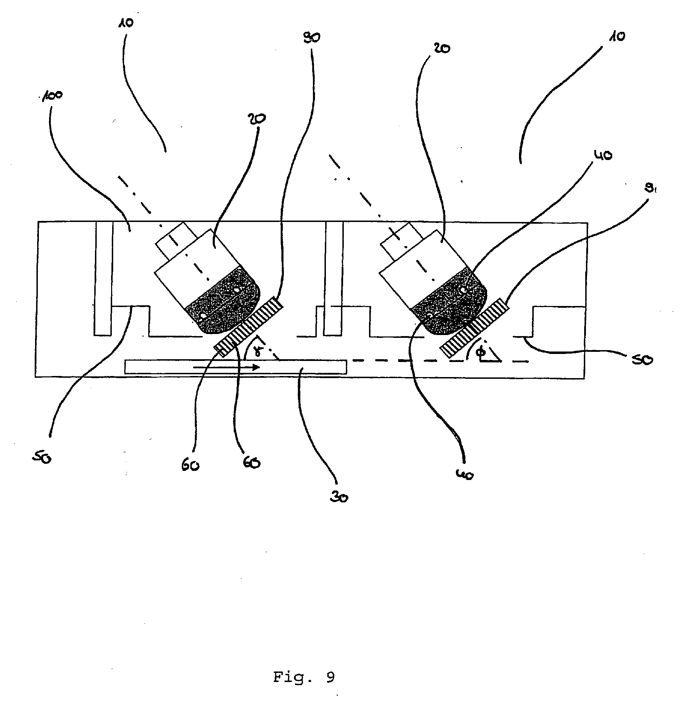

Um eine bestimmte Auftragsrichtung beim Sputtervorgang zu realisieren, sieht ein besonders bevorzugtes Ausführungsbeispiel der Erfindung vor, die Zerstäubungskathode mit Sputtertarget und die sich in Sputterrichtung dahinter befindende Filterstruktur unter einem Winkel zum Substrat anzubringen. Ein derartiger Aufbau ist in Fig. 9 dargestellt. Dabei handelt es sich um einen Inline-Prozess, bei dem ein Substrat 30 nacheinander durch wenigstens zwei PVD-Anlagen 10 geführt wird. Sowohl die Kathoden 20 mit den jeweiligen Sputtertargets 22 als auch die Filterstrukturen 90 stehen in einem Winkel γ zur Oberfläche des Substrats. Die Filter fokussieren jeweils den Sputterfluss der Kathode auf einen bestimmten engen Bereich, so dass ein gerichteter Sputterfluss entsteht. Die resultierende gerichtete Deposition von Sputtermaterial auf dem Substrat erfolgt unter dem eingestellten Winkel γ, der durch die Ausrichtung von Kathode und Filterstruktur bestimmt wird. Durch Änderung der Ausrichtung ändert sich auch der Aufbringwinkel.

Das Substrat wird in einem bestimmten Abstand mit einer Geschwindigkeit in der Größenordnung von 0,1 bis 12 m/min an der Kathode mit dem Filter vorbeigeführt, so dass das Substrat gemäß den Anforderungen mit Depositionsmaterial beschichtet wird. Die so realisierten Abscheidungs- bzw. Sputterraten hängen stark von den Randbedingungen wie z.B. der Sputterleistung, dem Sputterdruck und dem Targetmaterial ab. Ferner hat es einen Einfluss auf die Sputterrate, ob das Sputterregime reaktiv und das Target keramisch oder metallisch ist. Typische Abscheidungsraten liegen in einer derartigen Vorrichtung in der Größenordnung von 0,1 nm/min bis 1000 nm/min.

In einer besonders bevorzugten Ausführungsform der Erfindung unterscheiden sich die eingestellten Winkel in den PVD-Anlagen 10, so dass in den jeweiligen Stationen unterschiedlich gerichtete Sputtervorgänge erfolgen können. In der ersten Station wird das Substrat unter dem Winkel γ beschichtet, während die Deposition in der zweiten Station unter einem Winkel φ erfolgt. Dies kann beispielsweise bei der Herstellung von selbstjustierenden Serienverschaltungen von Dünnschichten erforderlich sein, bei der ein Substrat schichtweise Materialdepositionen unter verschiedenen Einfallswinkeln ausgesetzt wird.

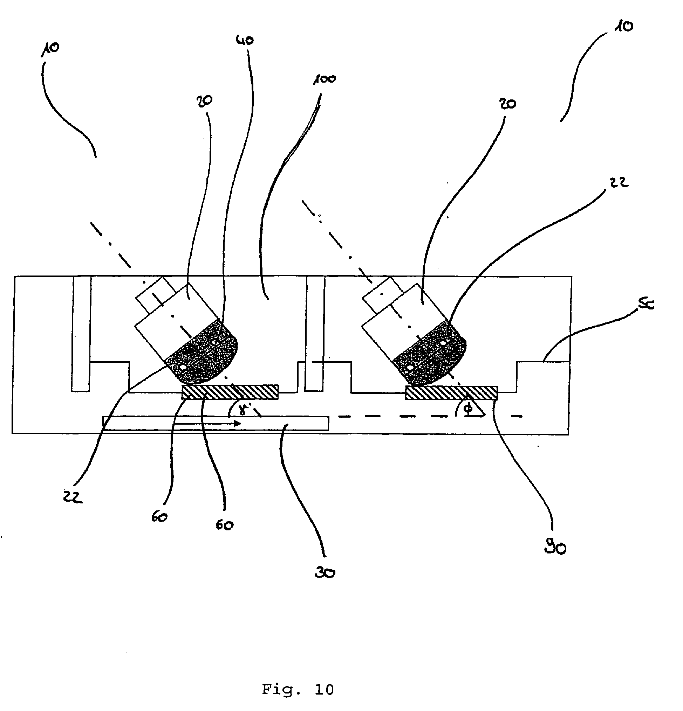

In Fig. 10 ist ein weiterer Inline-Prozess dargestellt, bei dem die einzelnen Kathoden 20 und Sputtertargets 22 in einem Winkel γ zum durchlaufenden Substrat 30 angebracht sind, die Filterstrukturen 90 dagegen so eingebracht sind, dass sie vorzugsweise parallel zur Oberfläche des Substrats verlaufen. Der Filter kann natürlich auch hier in einem beliebigen Winkel zur Substratoberfläche angeordnet sein. Die Einzelstrukturen 60 des Filters sind so aufgebildet, dass die Kanäle wiederum unter dem Winkel γ zum Substrat 30 stehen. So wird ebenfalls ein gerichtetes Aufbringen von Sputtermaterial unter einem bestimmten Winkel realisiert. Der jeweilige Winkel kann durch Ausrichten der Kathode 20 und Veränderung der Einzelstrukturen 60 des Filters 90 verändert werden.

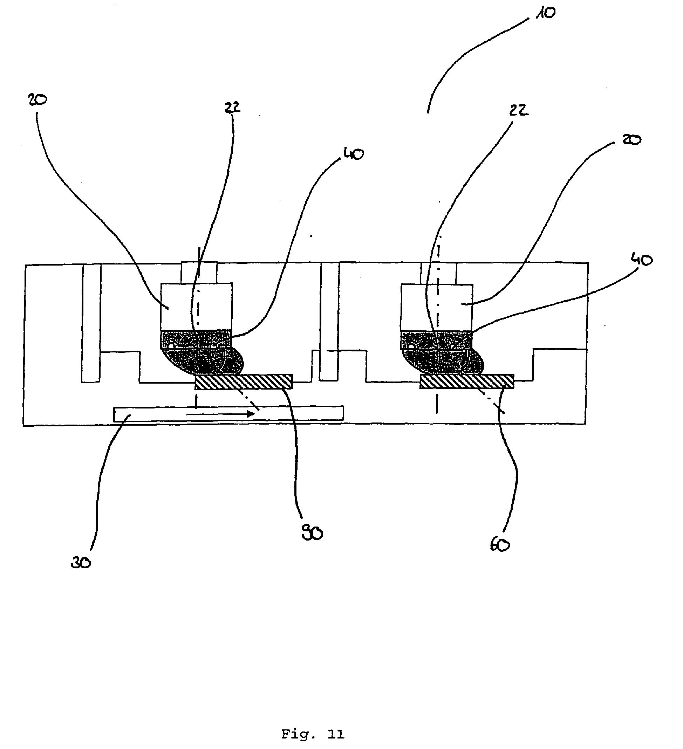

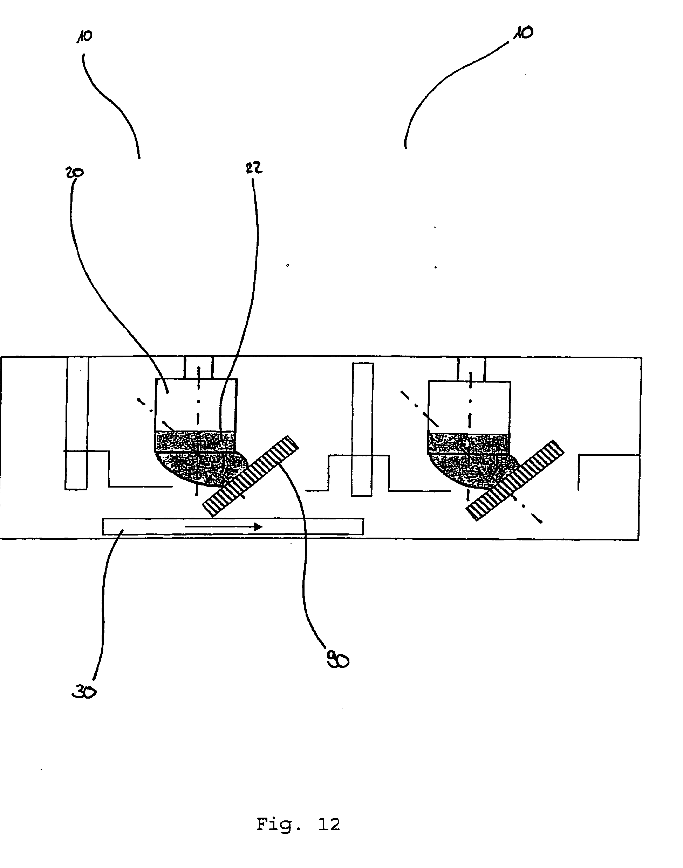

In Fig. 11 und Fig. 12 sind weitere Ausführungsbeispiele dargestellt, bei denen die Kathoden in einem beliebigen Winkel zum Substrat stehen und das Sputterplasma mit den Sputterstrahlen in einem Winkel zur Kathode stehen. In Fig. 11 steht die Kathode 20 beispielsweise parallel zur Oberfläche des Substrats 30, während die Sputterstrahlen so ausgelenkt sind, dass sie ein Feld bilden, das im Winkel ω geneigt ist. Dieses geneigte Feld wird durch den Filter 90 geleitet und seine Sputterstrahlen werden ebenfalls im Winkel ω auf das Substrat geleitet.

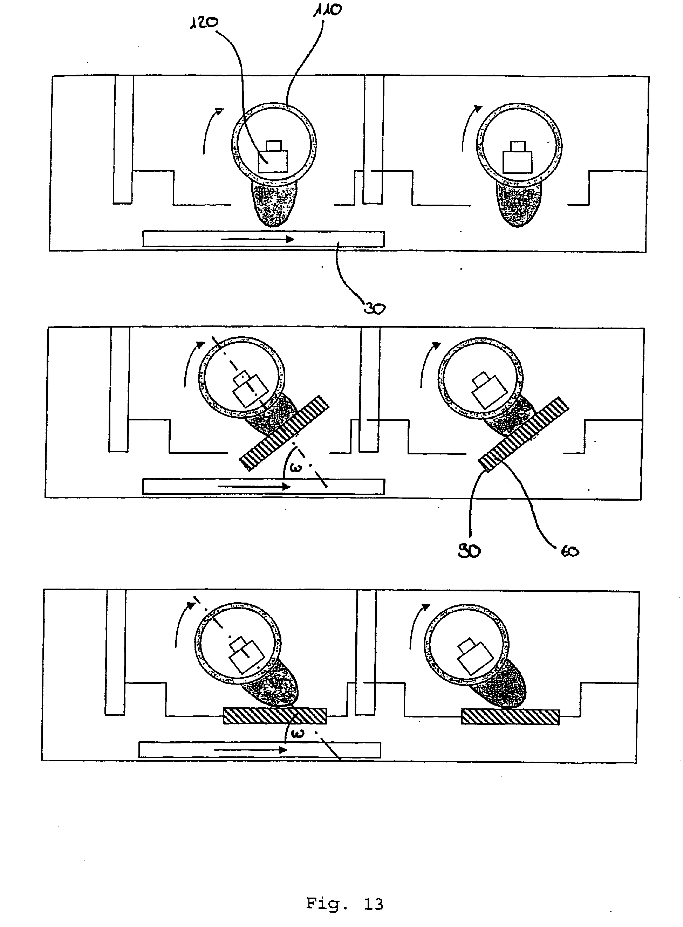

In Fig. 13 ist ein weiteres Ausführungsbeispiel dargestellt, bei dem Rotativkathoden mit rohrförmigem Targetmaterial 110 verwendet werden. Innerhalb dieses Targetrohrs befinden sich Magnete 120 und eine Wasserkühlung. Durch die Rotation des Targets wird das Targetmaterial gleichmäßig abgetragen. Werden nun die Magnete gedreht, wie es in der Zeichnung dargestellt ist, dreht sich auch das Plasma, und die Sputterteilchen werden in einem Winkel ω zum Substrat 30 abgeschieden. Die Stellung des Filters 90 mit den einzelnen Filterstrukturen 60 ist wiederum beliebig wählbar.

Die Ablenkung der gesputterten Teilchen durch Zusammenstöße ist abhängig von der freien Weglänge der Sputterteilchen und somit vom Sputterdruck in der Kammer 100. Der Sputterdruck hat ebenfalls einen Einfluss auf die Sputterrate, so dass für die jeweilige Anwendung ein Optimum gefunden werden muss.

Die erfindungsgemäße Einbringung einer Filterstruktur ist nicht auf das Verfahren des Sputterns in einer PVD-Anlage beschränkt, sondern ist vielmehr auch auf andere Verfahren anwendbar, bei denen ein gerichtetetes Aufbringen von Depositionsmaterial auf ein Substrat erfolgen soll. Weitere mögliche Anwendungsformen sind beispielsweise die Closed Space Sublimination, das Thermische Verdampfen sowie das Sprühen.

### Bezugszeichenliste:

- 10: PVD-Anlage
- 20: Zerstäubungskathode
- 21: Anode
- 22: Sputtertarget
- 30: Substrat
- 40: Punktquelle eines Sputtertargets
- 50: Blende
- 60: Einzelstruktur eines Filters
- 90: Mehrfachstruktur eines Filters
- 100: Kammer einer PVD-Anlage
- 110: Targetmaterial einer Rotativkathode
- 120: Magnet

## Patentansprüche

1. Verfahren zum gerichteten Aufbringen von Depositionsmaterial auf ein Substrat in einer PVD-Anlage, bei dem die von einem Sputtertarget (22) einer Zerstäubungskathode (20) abgesputterten Teilchenstrahlen durch einen Filter (90) mit mehreren kanalartigen Einzelstrukturen (60) auf das Substrat (30) geleitet werden, wobei der Sputterteilchenfluss auf einen engen Winkelbereich begrenzt wird, **dadurch gekennzeichnet, dass** die Materialstrahlen innerhalb einer Vorrichtung in einer ersten Station unter einem Winkel γ und in einer zweiten Station unter einem Winkel φ aufgebracht werden, wobei die Einfallswinkel verschieden voneinander sind.

2. Vorrichtung zum gerichteten Aufbringen von Depositionsmaterial unter einem Winkel auf ein Substrat in einer PVD-Anlage, bei der zwischen wenigstens einer Zerstäubungskathode (20) mit einem Sputtertarget (22) und dem Substrat (30) ein Filter (90) mit mehreren kanalartigen Einzelstrukturen (60) eingebracht ist, wobei der Sputterteilchenfluss auf einen engen Winkelbereich begrenzt wird, **dadurch gekennzeichnet, dass** die Vorrichtung Mittel zum Aufbringen von Depositionsmaterial unter einem Winkel γ in einer ersten Station und zum Aufbringen von Depositionsmaterial unter einem Winkel φ in einer zweiten Station aufweist, wobei die Einfallswinkel verschieden voneinander sind.

3. Vorrichtung nach Anspruch 2, **dadurch gekennzeichnet, dass** sowohl die Zerstäubungskathode (20) mit dem Sputtertarget (22) als auch der Filter (90) in einem Winkel γ zur Oberfläche des Substrates (30) angebracht sind.

4. Vorrichtung nach Anspruch 2, **dadurch gekennzeichnet, dass** die Zerstäubungskathode (20) mit dem Sputtertarget (22) in einem Winkel γ zur Oberfläche des Substrates (30) angebracht ist, während der Filter (90) parallel zur Oberfläche des Substrats (30) verläuft und die Kanäle (60) des Filters im Winkel γ zur Oberfläche des Substrats (30) verlaufen.

5. Vorrichtung nach nach Anspruch 2, **dadurch gekennzeichnet, dass** die Zerstäubungskathode (20) mit dem Sputtertarget (22) in einem Winkel γ zur Oberfläche des Substrates (30) angebracht ist, der Filter (90) in einem anderen Winkel zur Substratoberfläche verläuft, und die Kanäle (60) des Filters wieder im Winkel γ zur Oberfläche des Substrats (30) verlaufen.

6. Vorrichtung nach Anspruch 2, **dadurch gekennzeichnet, dass** die von der Zerstäubungskathode (20) abgesputterten Teilchenstrahlen in einem Winkel ω zur Kathode abgeschieden werden, der Filter (90) parallel oder in einem Winkel zur Substratoberfläche eingebracht ist und die Einzelstrukturen (60) des Filters (90) wiederum in einem Winkel ω zur Substratoberfläche verlaufen.

7. Vorrichtung nach einem oder mehreren der Ansprüche 2 bis 6, **dadurch gekennzeichnet, dass** es sich bei der Zerstäubungskathode um eine Rotativkathode handelt, deren Magnete (120) so eingestellt sind, dass die Sputterteilchenstrahlen in einem Winkel ω zur Substratoberfläche abgeschieden werden.

8. Vorrichtung nach einem oder mehreren der Ansprüche 2 bis 7, **dadurch gekennzeichnet, dass** der Filter (90) aus mehreren kanalförmigen Einzelstrukturen (60) mit quadratischem, rundem, rechteckigem und/oder wabenförmigen Querschnitt besteht.

9. Vorrichtung nach Anspruch 8, **dadurch gekennzeichnet, dass** die Breite B der Kanäle (60) der Filterstruktur (90) in der Größenordnung von 2 mm bis 25 mm liegt, wobei die Breite durch den weitesten Querschnitt der Einzelstrukturen (60) gegeben ist.

10. Vorrichtung nach einem oder mehreren der Ansprüche 2 bis 9, **dadurch gekennzeichnet, dass** sich der Öffnungswinkel β der Einzelstrukturen (60) aus den Beziehungen β = 2 x α und tan α = B/L berechnen lässt.

11. Vorrichtung nach Anspruch 10, **dadurch gekennzeichnet, dass** der Öffnungswinkel β in der Größenordnung von 10° bis 120° liegt.

12. Vorrichtung nach einem oder mehreren der Ansprüche 2 bis 11, **dadurch gekennzeichnet, dass** die Anzahl der kanalförmigen Einzelstrukturen (60) eines Filters (90) in der Größenordnung von etwa 1600/m² bis 250.000/m² liegt.

13. Vorrichtung nach einem oder mehreren der Ansprüche 2 bis 12, **dadurch gekennzeichnet, dass** die Abscheidungsrate der Vorrichtung mit Filter in der Größenordnung von 0,1 nm/min bis 1000 nm/min liegt.

## Claims

1. A method for the directed application of deposition material onto a substrate in a PVD installation in which the particle jets sputtered off by a sputter target (22) of a sputter cathode (20) are passed through a filter (90) having several channel-like individual structures (60) onto the substrate (30), the sputter particle flow being limited to a narrow angular range, **characterized in that** the material jets are applied inside a device in a first station at an angle γ and in a second station at an angle Φ, whereby the angles of incidence differ from each other.

2. A device for the directed application of deposition material at an angle onto a substrate in a PVD installation with which device a filter (90) having several channel-like individual structures (60) is installed between at least one sputter cathode (20) having a sputter target (22) and the substrate (30), the sputter particle flow being limited to a narrow angular range, **characterized in that** the device has means for applying deposition material at an angle γ in a first station and for applying deposition material at an angle φ in a second station, whereby the angles of incidence differ from each other.

3. The device according to claim 2, **characterized in that** the sputter cathode (20) with the sputter target (22) as well as the filter (90) are arranged at an angle γ relative to the surface of the substrate (30).

4. The device according to claim 2, **characterized in that** the sputter cathode (20) with the sputter target (22) is arranged at an angle γ relative to the surface of the substrate (30), whereas the filter (90) runs parallel to the surface of the substrate (30) and the channels (60) of the filter run at an angle γ relative to the surface of the substrate (30).

5. The device according to claim 2, **characterized in that** the sputter cathode (20) with the sputter target (22) is arranged at an angle γ relative to the surface of the substrate (30), the filter (90) runs at a different angle relative to the substrate surface, and the channels (60) of the filter once again run at an angle γ relative to the surface of the substrate (30).

6. The device according to claim 2, **characterized in that** the particle jets sputtered off by the sputter cathode (20) are deposited at an angle ω relative to the cathode, the filter (90) is installed parallel or at an angle relative to the substrate surface and the individual structures (60) of the filter (90) once again run at an angle ω relative to the substrate surface.

7. The device according to one or more of claims 2 to 6, **characterized in that** the sputter cathode is a rotary cathode whose magnets (120) are adjusted in such a way that the sputter particle jets are deposited at an angle ω relative to the substrate surface.

8. The device according to one or more of claims 2 to 7, **characterized in that** the filter (90) consists of several channel-like individual structures (60) having a square, round, rectangular and/or honeycomb-shaped cross section.

9. The device according to claim 8, **characterized in that** the width B of the channels (60) of the filter structure (90) lies in the order of magnitude of 2 mm to 25 mm, whereby the width is determined by the widest cross section of the individual structures (60).

10. The device according to one or more of claims 2 to 9, **characterized in that** the opening angle β of the individual structures (60) can be calculated from the relationships β = 2 x α and tan α = B/L.

11. The device according to claim 10, **characterized in that** the opening angle β lies in the order of magnitude of 10° to 120°.

12. The device according to one or more of claims 2 to 11, **characterized in that** the number of channel-shaped individual structures (60) of a filter (90) lies in the order of magnitude of approximately 1600/m² to 250,000/m².

13. The device according to one or more of claims 2 to 12, **characterized in that** the deposition rate of the device with a filter lies in the order of magnitude of 0.1 nm/min to 1000 nm/min.

## Revendications

1. Procédé d'application dirigée de matières de dépôt sur un substrat dans une installation de dépôt en phase vapeur, dans lequel des jets de particules projetés par une cible de projection (22) d'une cathode de pulvérisation (20) sont dirigés sur le substrat (30) à travers un filtre (90) comportant plusieurs structures individuelles(60) en forme de canaux, dans lequel le flux de particules projetées est limité à une zone angulaire étroite, **caractérisé en ce que** les jets de matière sont appliqués à l'intérieur d'un dispositif dans un premier poste suivant un angle Y et dans un deuxième poste suivant un angle Φ, les angles d'incidence étant différents entre eux.

2. Procédé d'application dirigée de matières de dépôt sur un substrat suivant un angle dans une installation de dépôt en phase vapeur, dans lequel, entre au moins une cathode de pulvérisation (20) comportant une cible de projection (22) et le substrat (30), est installé un filtre (90) comportant plusieurs structures individuelles (60)en forme de canaux, le flux de particules projetées étant limité à une zone angulaire étroite, **caractérisé en ce que** le dispositif comporte des moyens d'application de matière de dépôt suivant un angle Y dans un premier poste et d'application de matière de dépôt, suivant un angle Φ dans un deuxième poste, les angles d'incidence étant différents entre eux.

3. Procédé selon la revendication 2, **caractérisé en ce qu'**aussi bien la cathode de pulvérisation (20) comportant la cible de projection (22) que le filtre (90) sont installés suivant un angle Y par rapport à la surface du substrat (30).

4. Procédé selon la revendication 2, **caractérisé en ce que** la cathode de pulvérisation (20) comportant la cible de projection (22) est installée suivant un angle Y par rapport à la surface du substrat (30), tandis que le filtre (90) s'étend parallèlement à la surface du substrat (30) et que les canaux (60) du filtre s'étendent suivant l'angle Y par rapport à la surface du substrat (30).

5. Procédé selon la revendication 2, **caractérisé en ce que** la cathode de pulvérisation (20) comportant la cible de projection (22) est installée suivant un angle Y par rapport à la surface du substrat (30), que le filtre (90) s'étend suivant un autre angle par rapport à la surface du substrat (30) et que les canaux (60) du filtre s'étendent de nouveau suivant l'angle Y par rapport à la surface du substrat (30).

6. Procédé selon la revendication 2, **caractérisé en ce que** les jets de particules projetés par la cathode de pulvérisation (20) sont déposés suivant un angle ω par rapport à la cathode, le filtre (90) est intégré parallèlement ou suivant un angle par rapport à la surface du substrat et que les structures individuelles (60) du filtre (90) s'étendent de nouveau suivant un angle ω par rapport à la surface du substrat.

7. Procédé selon une ou plusieurs des revendications 2 à 6, **caractérisé en ce qu'**il s'agit, en ce qui concerne la cathode de pulvérisation, d'une cathode rotative dont les aimants (120) sont réglés de manière à ce que les jets de particules projetées soient déposés suivant un angle ω par rapport à la surface du substrat.

8. Procédé selon une ou plusieurs des revendications 2 à 7, **caractérisé en ce que** le filtre (90) est composé de plusieurs structures individuelles (60) en forme de canaux à section transversale quadratique, ronde, rectangulaire et/ou en nid d'abeille.

9. Procédé selon la revendication 8, **caractérisé en ce que** la largeur B des canaux (60) de la structure de filtre (90) se situe dans l'ordre de grandeur de 2 mm à 25 mm, la largeur étant donnée par la plus large section transversale des structures individuelles (60).

10. Procédé selon une ou plusieurs des revendications 2 à 9, **caractérisé en ce que** l'angle d'ouverture β des structures individuelles (60) peut être calculé à partir des équations β = 2 x α et tan α = B/L.

11. Procédé selon la revendication 10, **caractérisé en ce que** l'angle d'ouverture β se situe dans l'ordre de grandeur de 10° à 120°.

12. Procédé selon une ou plusieurs des revendications 2 à 11, **caractérisé en ce que** le nombre de structures individuelles (60) en forme de canaux d'un filtre (90) se situe dans l'ordre de grandeur d'approximativement 1.600/m² à 250.000 /m².

13. Procédé selon une ou plusieurs des revendications 2 à 12, **caractérisé en ce que** la vitesse de dépôt du dispositif à filtre se situe dans l'ordre de grandeur de 0,1 nm/min. à 1.000 nm/min.
